# EUROPEAN PATENT APPLICATION

(11) **EP 1 841 291 A1**
(43) Date of publication of application: **03.10.2007**
(21) Application number: 05842266.8
(22) Date of filing: 26.12.2005
(51) Int. Cl.: H05B 33/10

(54) **ORGANIC ELECTROLUMINESCENT DEVICE AND METHOD FOR MANUFACTURING SAME**

(30) Priority: 28.12.2004 JP 2004381106
(71) Applicant: IDEMITSU KOSAN CO., LTD., Tokyo 100-8321 (JP)
(72) Inventor: JUNKE, Tadanori, 2990293 (JP); KONDO, Hirofumi, 2990293 (JP); INOUE, Tetsuya, 2990293 (JP)
(74) Representative: Gille Hrabal Struck Neidlein Prop Roos
(86) International application number: PCT/JP2005/023718
(87) International publication number: WO 2006/070716

(57) **Abstract**

An organic EL device with a high luminance and a long life, and a method for producing the same are provided. An organic EL device including an anode 10, a cathode 30, and an organic thin layer 20 including one or a plurality of layers including at least an emitting layer 24, the organic thin layer being inserted between the anode 10 and the cathode 30, at least one of the layers 22, 24 and/or 26 having an oxygen concentration of 2,000 ppm or less. A method for producing the organic EL device, wherein the layers with an oxygen concentration of 2, 000 ppm or less are produced by a wet method.

## Description

### TECHNICAL FIELD

The invention relates to an organic electroluminescent (EL) device and a method for manufacturing the same, in particular, to a method for manufacturing an organic EL device by a wet method.

### BACKGROUND

An organic EL display is formed of an organic EL device comprising an anode, a cathode, which are opposing to each other, and an emitting layer containing an organic luminescent molecules being interposed therebetween. When applying voltage between the electrodes of the device, electrons injected from the cathode and holes injected from the anode recombine in the emitting layer. The organic luminescent molecules are excited by the recombination energy, and then return to the ground state from the excited state, releasing energy. The organic EL device emits light by converting this energy to light.

The organic EL display formed using the organic EL device having the above emission principle is a completely solid-state device, exhibits excellent visibility, and allows a reduction in weight and thickness. Moreover, the organic EL display can be driven at a low voltage of only several volts. Accordingly, the organic EL display is expected to be used as a color display and has been extensively studied.

An organic EL device is a current-driven emitting device. The device is heated when light emission is performed at a high current. When oxygen or moisture is present in each stacked layer or around the device, oxidation of the construction materials of the device is promoted. As a result, insufficient emission, the so-called "dark spot", is generated and grown due to modification of the construction materials. That is, oxygen or water causes the luminance of the organic EL device to be lowered, shortening the life of the organic EL device. To eliminate such influences of oxygen and moisture, Patent Document 1, for example, specifies that the oxygen concentration of the emitting device is 1 x 10¹⁹/cm³ or less. Patent Document 2 proposes production of an organic EL device in an inert gas with a water content of 5% or less and an oxygen concentration of 4, 000 ppm or less. Patent Document 3 proposes production of an organic EL device in an inert gas with an oxygen concentration of 100 ppm or less. By these methods, however, generation of dark spots could not be suppressed sufficiently.

Formation of each layer of an organic EL device is generally performed by a dry process such as vapor deposition. An attempt has been made to use a wet method such as application of a coating solution and printing for simplified process, increased productivity, and ready adaptation to large-sized organic EL devices (see Patent Documents 2 to 5).

An object of the invention is to provide an organic EL device which exhibits a high luminance and a long life and the production method thereof.
Patent Document 1: JP-A-2002-203682
Patent Document 2: JP-A-2004-55225
Patent Document 3: JP-A-2004-55452
Patent Document 4: JP-A-2004-164873
Patent Document 5: JP-A-2004-193101

### SUMMARY OF THE INVENTION

The invention provides the following organic EL device and method for producing the same.
1. An organic electroluminescent device comprising an anode, a cathode, and an organic thin layer comprising one or a plurality of layers including at least an emitting layer, the organic thin layer being inserted between the anode and the cathode,
   at least one of the layers having an oxygen concentration of 2,000 ppm or less.
2. The organic electroluminescent device according to 1, wherein the oxygen concentration of the organic thin layer is 2,000 ppm or less.
3. A method for producing the organic electroluminescent device according to 1, wherein the layer with an oxygen concentration of 2, 000 ppm or less is produced by a wet method.
4. The method for producing an organic electroluminescent device according to 3, wherein the layer is produced in an atmosphere of inert gas with a water content of 10 ppm or less and an oxygen concentration of 10 ppm or less.
5. The method for producing an organic electroluminescent device according to 3 or 4, wherein the layer is produced by a wet method using a solution with a water content of 20 ppm or less and an oxygen concentration of 10 ppm or less.

The invention provides an organic EL device with a high luminance and a long life, as well as a method for producing the same.

### BRIEF DESCRIPTION OF DRAWINGS

FIG. 1 is a cross-sectional view showing an embodiment of an organic EL device according to the invention.
FIG. 2 is a graph showing the oxygen concentration in a film produced in Preparation Example 1 measured by the SIMS method.

### BEST MODE FOR CARRYING OUT THE INVENTION

The organic EL device of the invention comprises an anode, a cathode, and an organic thin layer comprising one or a plurality of layers including at least an emitting layer, the organic thin layer being inserted between the anode and the cathode. At least one of the layers has an oxygen concentration of 2,000 ppm or less, preferably 1,000 ppm or less.
The oxygen concentration of 2, 000 ppm or less suppresses the occurrence of dark spots, leading to a high luminance and long life. The oxygen concentration in the film is measured by the secondary ion mass spectrometry (SIMS).
It is preferred that the oxygen concentration in the entire organic thin layer be 2,000 ppm or less, more preferably 1,000 ppm or less.

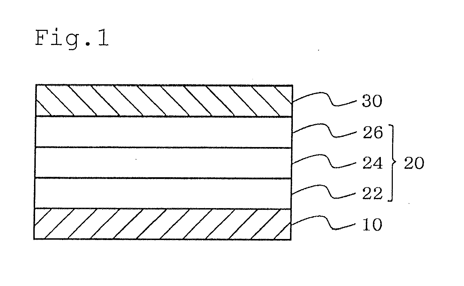

FIG. 1 is a cross-sectional view showing an embodiment of the organic EL device according to the invention.
The organic EL device has a cathode 30, an anode 10, and an organic thin layer 20 being interposed therebetween. The organic thin layer 20 is composed of a hole-injecting layer 22, an emitting layer 24, and an electron-injecting layer 26. The oxygen concentration of at least one of the hole-injecting layer 22, the emitting layer 24, and the electron-injecting layer 26 is 2,000 ppm or less. It is preferred that the oxygen concentration of the emitting layer 24 be 2,000 ppm or less. It is further preferred that the oxygen concentration of the layer formed of all the hole-injecting layer 22, the emitting layer 24, and the electron-injecting layer 26 be 2,000 ppm or less.

A method for producing an organic EL device of the invention is described below.
The layer with an oxygen concentration of 2,000 ppm or less is preferably prepared by a wet method.
The wet method as referred to herein means a method in which a solution obtained by dissolving a specific compound in a solvent is used, such as the coating method, the inkjet method, the spray method, the spin coating method, the dipping coating method, the screen printing method, the roll coating method, and the LB method.
The oxygen concentration of the layer can be made 2,000 ppm or less by decreasing the oxygen concentration of the solution, performing film formation at a low oxygen atmosphere, and the like.
For example, if spin coating is used, film formation is conducted in an inert gas atmosphere preferably with a water content of 10 ppm or less and an oxygen concentration of 10 ppm or less, more preferably with a water content of 5 ppm or less and an oxygen concentration of 5 ppm or less. As the inert gas, nitrogen, argon, helium or the like can be given.
The water content of an inert gas is obtained from a dew point measured using a dew-point hygrometer. The oxygen concentration can be measured by an oxygen analyzer.
The water content of an inert gas can be decreased by drying using a desiccant such as a molecular sheave. The oxygen concentration of an inert gas can be decreased by reacting oxygen with a platinum catalyst or the like, adsorbing oxygen to a deoxidant, or the like.

Preferably, the water content of the solution is made 20 ppm or less and the oxygen concentration is made 10 ppm or less, more preferably the water content of the solution is made 10 ppm or less and the oxygen concentration is made 5 ppm or less.
The water content of the solution can be measured by the Karl Fischer Titration method, and the oxygen concentration can be measured using a dissolved oxygen meter.

Methods for reducing the water content and the oxygen concentration of the solution generally include distillation purification, bubbling using an inert gas such as argon and nitrogen, drying using a desiccant represented by a molecular sheave, use of a degasser, freeze-deairing and freeze-drying.

Examples of the solvent for dissolving a luminous compound or the like used in the wet method include an alcohol-based solvent such as methanol, ethanol, propanol, isopropanol, n-butanol, t-butanol, pentanol, hexanol, cyclohexanol, methyl cellosolve, ethyl cellosolve, ethylene glycol; a halogenated hydrocarbon-based solvent such as dichloromethane, dichloroethane, chloroform, carbon tetrachloride, tetrachloroethane, trichloroethane, chlorobenzene, dichlorobenzene, and chlorotoluene; an ether-based solvent such as dibutyl ether tetrahydofuran, dioxane, and anisole; an aromatic solvent such as benzene, toluene, xylene, and ethyl benzene; a paraffin-based solvent such as hexane, octane, decane, and tetralin; an ester-based solvent such as ethyl acetate, butyl acetate, and amyl acetate; an amide-based solvent such as N,N-dimethylformamide, N,N-dimethylacetoamide, and N-methylpyrrolidinone; a ketone-based solvent such as acetone, methyl ethyl ketone, cyclohexanone, and isophorone; an amine-based solvent such as pyridine, quinoline, and aniline; a nitrile-based solvent such as acetonitrile and valeronitrile; and a sulfur-based solvent such as thiophene and carbon disulfide. These solvents may be used singly or in combination of two or more.
Of these solvents, an aromatic-based solvent such as toluene and xylene is preferable.

The structure of the organic EL device of the invention is described below. The typical device structure is as follow, but not limited thereto.
(1) Anode/emitting layer/cathode
(2) Anode/hole-injecting layer/emitting layer/cathode
(3) Anode/emitting layer/electron-injecting layer/cathode
(4) Anode/hole-injecting layer/emitting layer/electron-injecting layer/cathode (FIG. 1)
(5) Anode/organic semiconductor layer/emitting layer/cathode
(6) Anode/organic semiconductor layer/electron barrier layer/emitting layer/cathode
(7) Anode/organic semiconductor layer/emitting layer/adhesion improving layer/cathode
(8) Anode/hole-injecting layer/hole-transporting layer/emitting layer/electron-injecting layer/cathode
(9) Anode/insulative layer/emitting layer/insulative layer/cathode
(10) Anode/inorganic semiconductive layer/insulative layer/emitting layer/insulative layer/cathode
(11) Anode/organic semiconductor layer/insulative layer/emitting layer/insulative layer/cathode
(12) Anode/insulative layer/hole-injecting layer/hole-transporting layer/emitting layer/insulative layer/cathode
(13) Anode/insulative layer/hole-injecting layer/hole-transporting layer/emitting layer/electron-injecting layer/cathode
   Of these, normally, structure (8) is preferably used.

In the above device, one or a plurality of organic layers being interposed between an anode and a cathode correspond to the organic thin layer.
If the above layers are formed by the wet process, it is necessary to select a compound that can be dissolved in a solvent.

When an emitting layer is formed by the wet process, an anthracene compound or a pyrene compound described in PCT/JP03/10402, PCT/JP2004/018111, and Japanese Patent Application No. 2004-157571 can be used as a luminescent compound. The emitting layer may contain a fluorescent or a phosphorescent dopant.

As the phosphorescent dopant, a styrylamine compound represented by the following formula (1) or an arylamine compound represented by the following formula (2) can be used.

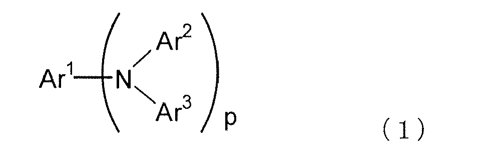

wherein Ar¹ is a group selected from phenyl, biphenyl, terphenyl, stilbene and distyrylaryl, Ar² and Ar³ are independently a hydrogen atom or an aromatic group having 6 to 20 carbon atoms, and p is an integer of 1 to 4, provided that Ar¹ to Ar³ may be substituted. More preferably, Ar² and/or Ar³ are substituted by a styryl group.

As the aromatic group having 6 to 20 carbon atoms, phenyl, naphthyl, anthranyl, phenanthryl, and terphenyl are preferable. 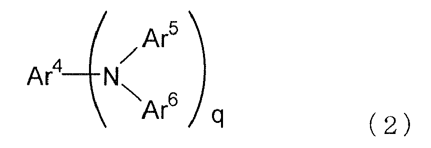 wherein Ar⁴ to Ar⁶ are a substituted or unsubstituted aryl group having 5 to 40 nucleus atoms. q is an integer of 1 to 4.

As the aryl group having 5 to 40 nucleus atoms, phenyl, naphthyl, anthranyl, phenanthryl, pyrenyl, cholonyl, biphenyl, terphenyl, pyrolyl, furanyl, thiophenyl, benzthiophenyl, oxadiazolyl, diphenylantranyl, indolyl, carbazolyl, pyridyl, benzoquinolyl, fluoranthenyl, acenapthofluoranthenyl, stilbene, or the like are preferable. The aryl group having 5 to 40 nucleus atoms may be substituted with a substituent. Examples of the preferred substituent include an alkyl group having 1 to 6 carbon atoms (ethyl, methyl, i-propyl, n-propyl, s-butyl, t-butyl, pentyl, hexyl, cyclopentyl, cyclohexyl, or the like); an alkoxy group having 1 to 6 carbon atoms (ethoxy, methoxy, i-propoxy, n-propoxy, s-buthoxy, t-buthoxy, penthoxy, hexyloxy, cyclopentoxy, cyclohexyloxy, or the like); an aryl group having 5 to 40 nucleus atoms; an amino group substituted with an aryl group having 5 to 40 nucleus atoms; an ester group with an aryl group having 5 to 40 nucleus atoms; an ester group with an alkyl group having 1 to 6 carbon atoms; a cyano group; a nitro group; and a halogen atom (chlorine, bromine, iodine, or the like).

The phosphorous dopant is preferably a metal complex containing at least one metal selected from iridium (Ir), ruthenium (Ru), palladium (Pd), platinum (Pt) , osmium (Os) and rhenium (Re). The ligand preferably has at least one skeleton selected from phenylpyridine, bipyridyl, and phenanthroline. Specific examples of such metal complex include, but not limited to, tris(2-phenylpyridine)iridium, tris(2-phenylpyridine)ruthenium, tris(2-phenylpyridine)palladium, bis(2-phenylpyridine)platinum, tris(2-phenylpyridine)osmium, tris(2-phenylpyridine)rhenium, platinum octaethyl porphyrin, platinum octaphenyl porphyrin, palladium octaethyl porphyrin, and palladium octaphenyl porphyrin. A suitable complex is selected according to a required color of emitted light, device performance, and a relationship with a host compound.

The hole-injecting/transporting layer is a layer for helping the injection of holes into the emitting layer to transport the holes to a light emitting region. The hole mobility thereof is large and the ionization energy thereof is usually as small as 5.5 eV or less. Such a hole-injecting/transporting layer is preferably made of a material which can transport holes to the emitting layer at a low electric field intensity. The hole mobility thereof is preferably at least 10⁻⁴ cm²/V·second when an electric field of, e.g., 10⁴ to 10⁶ V/cm is applied.

Any materials which have the above preferable properties can be used as the material for forming the hole-injecting/transporting layer without particular limitation. The material for forming the hole-injecting/transporting layer can be arbitrarily selected from materials which have been widely used as a material transporting carriers of holes in photoconductive materials and known materials used in a hole-injecting layer of organic EL devices.
For example, an aromatic tertiary amine, a hydrazone derivative, a carbazole derivative, a triazole derivative, an imidazole derivative, a polyvinyl carbazole, polyethylene dioxythiophene/polysulfonic acid (PEDOT/PSS) or the like can be given. Specific examples include triazole derivatives (see USP No. 3, 112, 197 and others), oxadiazole derivatives (see USP No. 3,189,447 and others), imidazole derivatives (see JP-B-37-16096 and others), polyarylalkane derivatives (see USP Nos. 3,615,402, 3,820,989 and 3,542,544, JP-B-45-555 and 51-10983, JP-A-51-93224, 55-17105, 56-4148, 55-108667, 55-156953 and 56-36656, and others), pyrazoline derivatives and pyrazolone derivatives (see USP Nos. 3,180,729 and 4,278,746, JP-A-55-88064, 55-88065, 49-105537, 55-51086, 56-80051, 56-88141, 57-45545, 54-112637 and 55-74546, and others), phenylene diamine derivatives (see USP No. 3,615,404, JP-B-51-10105, 46-3712 and 47-25336, JP-A-54-53435, 54-110536 and 54-119925, and others), arylamine derivatives (see USP Nos. 3,567,450, 3,180,703, 3,240,597, 3,658,520, 4,232,103, 4,175,961 and 4,012,376, JP-B-49-35702 and 39-27577, JP-A-55-144250, 56-119132 and 56-22437, DE1,110,518, and others), amino-substituted chalcone derivatives (see USP No. 3, 526, 501, and others), oxazole derivatives (ones disclosed in USP No. 3,257,203, and others), styrylanthracene derivatives (see JP-A-56-46234, and others), fluorenone derivatives (JP-A-54-110837, and others), hydrazone derivatives (see USP Nos. 3,717,462, JP-A-54-59143, 55-52063, 55-52064, 55-46760, 55-85495, 57-11350, 57-148749 and 2-311591, and others), stilbene derivatives (see JP-A-61-210363, 61-228451, 61-14642, 61-72255, 62-47646, 62-36674, 62-10652, 62-30255, 60-93455, 60-94462, 60-174749 and 60-175052, and others), silazane derivatives (USP No. 4, 950, 950), polysilanes (JP-A-2-204996), aniline copolymers (JP-A-2-282263), and electroconductive high molecular oligomers (in particular thiophene oligomers) disclosed in JP-A-1-211399.

The above-mentioned substances can be used as the material of the hole-injecting layer. The following can also be used: porphyrin compounds, aromatic tertiary amine compounds and styrylamine compounds (see USP No. 4, 127, 412, JP-A-53-27033, 54-58445, 54-149634, 54-64299, 55-79450, 55-144250, 56-119132, 61-295558, 61-98353 and 63-295695, and the like). Aromatic tertiary amine compounds may particularly be used.

The following can also be given as examples: 4,4'-bis(N-(1-naphthyl)-N-phenylamino)biphenyl (hereinafter abbreviated as "NPD"), which has in the molecule thereof two condensed aromatic rings, disclosed in USP No. 5,061,569, and 4,4',4"-tris(N-(3-methylphenyl)-N-phenylamino)triphenylamin e (hereinafter abbreviated as "MTDATA"), wherein three triphenylamine units are linked to each other in a star-burst form, disclosed in JP-A-4-308688.
Inorganic compounds such as p-type Si and p-type SiC as well as aromatic dimethylidene type compounds can also be used as the material of the hole-injecting layer.

This hole-injecting/transporting layer may be a single layer made of one or two or more of the above-mentioned materials, or may be stacked hole-injecting/transporting layers made of different compounds.

The organic semiconductor layer is a layer for helping the injection of holes or electrons into the emitting layer, and is preferably a layer having an electric conductivity of 10⁻¹⁰ S/cm or more. As the material of such an organic semiconductor layer, electroconductive oligomers such as thiophene-containing oligomers or arylamine-containing oligomers disclosed in JP-A-8-193191, and electroconductive dendrimers such as arylamine-containing dendrimers may be used.

The electron-injecting layer is a layer which assists injection of electrons into the emitting layer, and exhibits a high electron mobility. An adhesion-improving layer is a type of the electron-injecting layer formed of a material which exhibits excellent adhesion to the cathode. The material used in the electron-injeting layer is preferably a metal complex of 8-hydroxyquinoline or 8-hydroxyquinoline derivative, or an oxadiazole derivative.

As specific examples of a metal complex of 8-hydroxyquinoline or 8-hydroxyquinoline derivative, metal chelate oxinoid compounds including a chelate of oxine (usually, 8-quinolinol or 8-hydroxyquinoline) can be given. For example, tris(8-quinolinol)aluminum (Alq) may be used in the electron-injecting layer.
An electron-transporting compound of the following general formula can be given as the oxadiazole derivative.

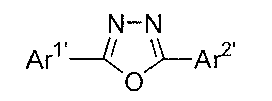

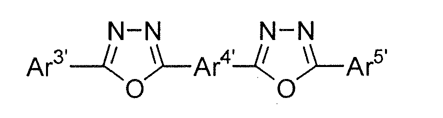

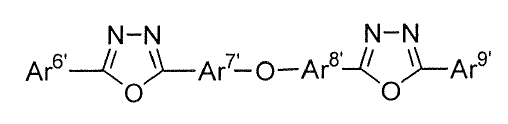

wherein Ar^{1'}, Ar^{2'}, Ar^{3'}, Ar^{5'}, Ar ^{6'} and Ar^{9'} are independently a substituted or unsubstituted aryl group and may be the same or different, and Ar^{4'}, Ar^{7'} and Ar^{8'} are independently a substituted or unsubstituted arylene group and may be the same or different.
As examples of the aryl group, a phenyl group, a biphenyl group, an anthranyl group, a perylenyl group, and a pyrenyl group can be given. As examples of the arylene group, a phenylene group, a naphthylene group, a biphenylene group, an anthranylene group, a perylenylene group, a pyrenylene group, and the like can be given. As the substituent, an alkyl group having 1 to 10 carbon atoms, an alkoxy group having 1 to 10 carbon atoms, a cyano group, and the like can be given. The electron-transporting compound is preferably one from which a thin film can be formed.

The following compounds can be given as specific examples of the electron-transporting compound.

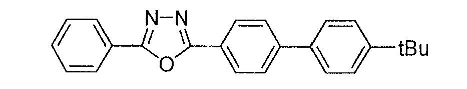

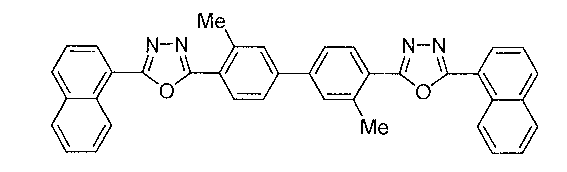

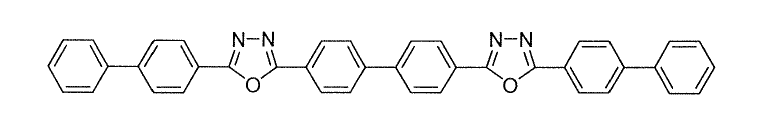

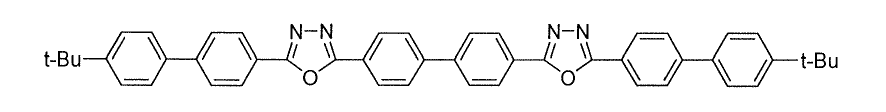

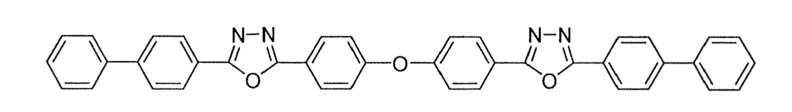

In the organic EL device, an electron-injecting layer made of an insulator or a semiconductor may further be provided between a cathode and an organic layer. By providing the layer, current leakage can be effectively prevented to improve the injection of electrons.
As the insulator, at least one metal compound selected from the group consisting of alkali metal calcogenides, alkaline earth metal calcogenides, halides of alkali metals and halides of alkaline earth metals can be preferably used. When the electron-injecting layer is formed of the alkali metal calcogenide or the like, the injection of electrons can be preferably further improved. Specifically preferable alkali metal calcogenides include Li₂O, LiO, Na₂S, Na₂Se and NaO and preferable alkaline earth metal calcogenides include CaO, BaO, SrO, BeO, BaS and CaSe. Preferable halides of alkali metals include LiF, NaF, KF, LiCl, KCl and NaCl. Preferable halides of alkaline earth metals include fluorides such as CaF₂, BaF₂, SrF₂, MgF₂ and BeF₂ and halides other than fluorides.

Semiconductors forming an electron-transporting layer include one or combinations of two or more of oxides, nitrides, and oxidized nitrides containing at least one element of Ba, Ca, Sr, Yb, Al, Ga, In, Li, Na, Cd, Mg, Si, Ta, Sb and Zn. An inorganic compound forming an electron-transporting layer is preferably a microcrystalline or amorphous insulating thin film. When the electron-transporting layer is formed of the insulating thin films, more uniformed thin film is formed, whereby pixel defects such as a dark spot are decreased.
Examples of such an inorganic compound include the above-mentioned alkali metal calcogenides, alkaline earth metal calcogenides, halides of alkali metals, and halides of alkaline earth metals.

In the organic EL device, pixel defects based on leakage or a short circuit are easily generated since an electric field is applied to the super thin film. In order to prevent this, it is preferred to insert an insulator thin layer between the pair of electrodes.
Examples of the material used in the insulative layer include aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium oxide, and vanadium oxide. A mixture or laminate thereof may be used.

The film thickness of each of the organic layers constituting the organic thin layer in the organic EL device of the invention is not particularly limited. In general, defects such as pinholes are easily generated when the film thickness is too small. Conversely, a high applied voltage becomes necessary, leading to low efficiency, when the film thickness is too large. Usually, therefore, the film thickness is preferably in the range of several nanometers to one micrometer.

If the above-mentioned layers are formed by the wet method, the above-mentioned compounds are dissolved in a solvent which is capable of dissolving them.
When forming the layers without using the wet method, the layers may be formed by a known method such as vacuum deposition.

The anode of the organic EL device plays a role for injecting holes into its hole-injecting/transporting layer or emitting layer. The anode effectively has a work function of 4.5 eV or more. Indium tin oxide alloy (ITO), tin oxide (NESA), gold, silver, platinum, copper, and the like may be used as the material for the anode.
The anode can be formed by forming these electrode materials into a thin film by vapor deposition, sputtering or the like.
In the case where emission from the emitting layer is outcoupled through the anode, the transmittance of the anode to the emission is preferably more than 10%. The sheet resistance of the anode is preferably several hundreds Ω/□ or less. The film thickness of the anode, which varies depending upon the material thereof, is usually from 10 nm to 1 µm, preferably from 10 to 200 nm.

The cathode of the organic EL device plays a role for injecting electrons into its electron-injecting/transporting layer or emitting layer. For the cathode, the following may be used: an electrode substance made of a metal, an alloy or an electroconductive compound, or a mixture thereof which has a small work function (4 eV or less). Specific examples of the electrode substance include sodium, sodium-potassium alloy, magnesium, lithium, magnesium/silver alloy, aluminum/aluminum oxide, aluminum/lithium alloy, indium, and rare earth metals.
This cathode can be formed by making the electrode substances into a thin film by vapor deposition, sputtering or some other method. In the case where emission from the emitting layer is outcoupled through the cathode, it is preferred to make the transmittance of the cathode to the emission larger than 10%. The sheet resistance of the cathode is preferably several hundreds Ω/□ or less, and the film thickness thereof is usually from 10 nm to 1 µm, preferably from 50 to 200 nm.

The organic EL device is usually formed on a transparent substrate. The transparent substrate is a substrate for supporting the organic EL device, and is preferably a flat and smooth substrate having a transmittance of 50% or more to light rays within visible ranges of 400 to 700 nm.
Specific examples thereof include glass plates and polymer plates. Examples of the glass plate include soda-lime glass, barium/strontium-containing glass, lead glass, aluminosilicate glass, borosilicate glass, barium borosilicate glass, and quartz. Examples of the polymer plate include polycarbonate, acrylic polymer, polyethylene terephthalate, polyethersulfide, and polysulfone.

### EXAMPLES

The oxygen concentration and the water content of Preparation Examples, Example and Comparative Example were measured by the following methods.
(1) Method for measuring an oxygen concentration in a glove box
Measured by an oxygen analyzer LC750L manufactured by Toray Engineering Co., Ltd.
(2) Method for measuring water content in a glove box
A dew point was measured using a dew-point hygrometer manufactured by Michell Japan K.K. The relationship between the water content and the dew point is shown in Table 1.
Based on the relationship, the water content was obtained from the measured dew point.

**Table 1**

| Dew Point and Water content | |
|---|---|
| Dew Point | Water content (Volume) |
| 20°C | 2.31% |
| 0°C | 0.60% |
| -20°C | 0.10% |
| -40°C | 0.013% |
| -60°C | 0.0011% |
| -80°C | 0.53 ppm |
| -100°C | 0.014 ppm |

(3) Method for measuring an oxygen concentration of a solution
Toluene was used as a solvent. The oxygen concentration of a solution was measured using a dissolved oxygen monitor (UC-12-SOL, manufactured by Central Kagaku Corp.). The value (mg/L) obtained by the measurement was converted providing that the specific gravity of toluene was 0.8669 (20°C) and expressed as ppm.
(4) Method for measuring a water content of a solution
The water content was measured using a moisture meter (Ca-06, manufactured by Dia Instruments Co., Ltd.).
(5) Method for measuring an oxygen concentration of a film
The oxygen concentration of a film was measured by the secondary ion mass spectrometry (SIMS) method. (For details of SIMS, refer to "Secondary Ion Mass Spectrometry", Selected Book on Surface Analysis Technology, edited by Surface Science Society of Japan and sold by Maruzen Co., Ltd.)
A target organic thin film portion was identified from a depth profile obtained by SIMS. The oxygen concentration was identified from a ratio of the average detected carbon amount (counts/sec) to the average detected oxygen amount (counts/sec) in a range that 50% of the thickness of the thin film was included.

### Preparation Example 1

### (1) Preparation of solution

The inside of a glove box was sufficiently replaced by a nitrogen gas. The oxygen concentration and the dew point at that time were 0.6 ppm and -70°C (water content: 3 ppm), respectively.
After being subjected to nitrogen bubbling in the glove box with an oxygen concentration of 0.6 ppm and a dew point of -70°C, toluene was passed through a degasser (DEGASSER Multiplex U005, manufactured by ERC Inc.). The water content and the oxygen concentration of the toluene thus prepared were 1 ppm and 0.6 ppm, respectively.
The compound A6 represented by the following formula was vacuum-dried, introduced into the glove box without bringing into contact with air, and dissolved in the above-prepared toluene such that the concentration of the compound A6 became 1 wt%.
The water content and the oxygen concentration of the resultant solution were 1 ppm and 0.6 ppm, respectively. The compound A6 was produced by a method described in Japanese Patent Application No. 2003-417037.

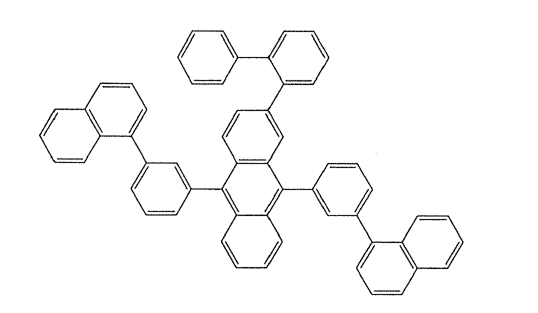

### (2) Formation of film and measurement of oxygen concentration of film

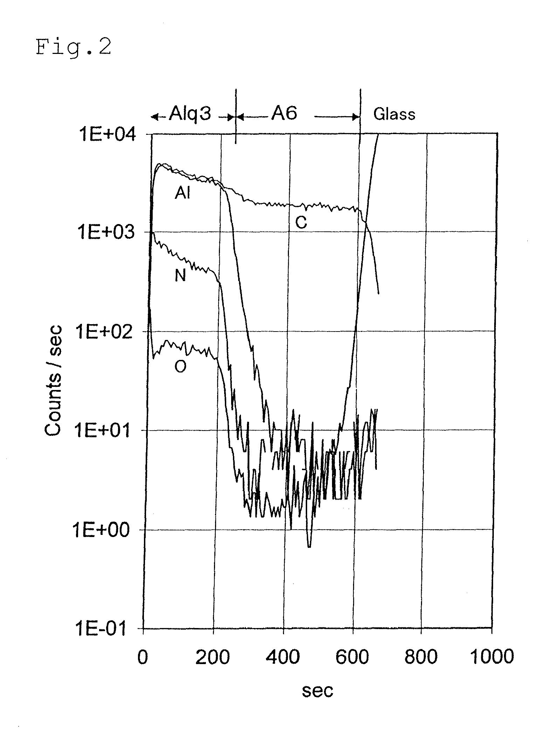

A grass substrate of 25 mm by 75 mm by 1. 0 mm was subjected to ultrasonic cleaning with isopropyl alcohol for 5 minutes, and cleaned with ultraviolet rays and ozone for 30 minutes. The substrate was brought into a glove box with an oxygen concentration of 1 ppm and a dew point of -71°C (water content: 2 ppm). The solution prepared in the Preparation Example 1 (1) was applied on the substrate by spin coating to form a film. The substrate was baked using a hot plate at a temperature of 115°C for 30 minutes in the glove box. The film thickness was 50 nm. The substrate was secured to a substrate holder of a vacuum deposition apparatus without bringing into contact with air. A 10 nm-thick tris (8-quinolinol) aluminum film (Alq film) was formed on the film of the compound A6 by vacuum deposition.
The oxygen concentration of the film was measured by the SIMS method. The results obtained are shown in FIG. 2. The film formed by spin coating was identified to correspond to the range between 240 sec and 600 sec. The average values of the carbon concentration and the oxygen concentration were obtained from the average values of the range between 330 sec and 510 sec. The oxygen concentration of the film was 1,090 ppm.

### Preparation Example 2

### (1) Preparation of solution

A solution was prepared in the same manner as in Preparation Example 1(1), except that the oxygen concentration and the dew point in the glove box were 2 ppm and -70°C, and the water content and the oxygen concentration of the solvent were 5 ppm and 2 ppm, respectively. The water content and the oxygen concentration of the prepared solution were 5 ppm and 2 ppm, respectively.

### (2) Formation of film and measurement of oxygen concentration of film

A film was formed in the same manner as in Preparation Example 1(2) using the solution prepared in (1) above. The oxygen concentration of the film formed by spin coating was 1,510 ppm.

### Comparative Preparation Example 1

### (1) Preparation of solution

A solution was prepared in the same manner as in Preparation Example 1(1), except that nitrogen bubbling and use of the degasser were omitted. The water content and the oxygen concentration were 30 ppm and 20 ppm, respectively.

### (2) Formation of film and measurement of oxygen concentration of film

Using the solution prepared in (1) above, a film was formed in the same manner as in Preparation Example 1 (2), except that the oxygen concentration and the dew point in the glove box were 35 ppm and -40°C (water content: 130 ppm). The oxygen concentration of the film formed by spin coating was 6, 080 ppm.

### Example 1 (fabrication of organic EL device]

A grass substrate of 25 mm by 75 mm by 1.1 mm thick with an ITO transparent electrode (anode) (GEOMATEC CO., LTD.) was subjected to ultrasonic cleaning with isopropyl alcohol for 5 minutes, and cleaned with ultraviolet rays and ozone for 30 minutes. On the substrate, a 100 nm-thick film of polyethylene dioxythiophene/polystyrene sulfonic acid (PEDOT/PSS), as a hole-injecting layer, was formed by spin coating. The substrate was brought into a glove box with an oxygen concentration of 0. 6 ppm and a dew point of -70°C (water content: 3 ppm). On the PEDOT/PSS film, an emitting layer was formed by spin coating the solution prepared in Preparation Example 1 (1) in the same manner as in Preparation Example 1 (2). An Alq film was formed thereon in the same manner as in Preparation Example 1(2). The Alq film functioned as an electron-transporting layer. Then, Li as a reductive dopant (Li source: manufactured by SAES Getters Co., Ltd.) and Alq were co-deposited, whereby an Alq:Li film was formed as an electron-injecting layer (cathode). Metal aluminum was deposited on the Alq:Li film to form a metallic cathode, whereby an organic EL device was fabricated.
The luminescent efficiency and the half life of luminance when the device was driven at 100 cd/m² was 0.9 cd/A and 230 hours.

### Comparative Example 1 (fabrication of organic EL device)

An organic EL device was prepared in the same manner as in Example 1, except that the solution prepared in Comparative Preparation Example 1(1) was used instead of the solution prepared in Preparation Example 1(1), and the oxygen concentration and the dew point in the glove box were 36 ppm and -41°C (water content: 110 ppm), respectively.
The luminescent efficiency and the half life of luminance when the device was driven at 100 cd/m² was 0. 7 cd/A and 80 hours.

### INDUSTRIAL APPLICABILITY

The organic EL device of the invention can be suitably used as a planar emitting body such as a flat panel display, backlight of a copier, a printer, or a liquid crystal display, light sources for instruments, a display panel, a navigation light, and the like.

## Claims

1. An organic electroluminescent device comprising an anode, a cathode, and an organic thin layer comprising one or a plurality of layers including at least an emitting layer, the organic thin layer being inserted between the anode and the cathode,
at least one of the layers having an oxygen concentration of 2,000 ppm or less.

2. The organic electroluminescent device according to claim 1, wherein the oxygen concentration of the organic thin layer is 2,000 ppm or less.

3. A method for producing the organic electroluminescent device according to claim 1, wherein the layer with an oxygen concentration of 2, 000 ppm or less is produced by a wet method.

4. The method for producing an organic electroluminescent device according to claim 3, wherein the layer is produced in an atmosphere of inert gas with a water content of 10 ppm or less and an oxygen concentration of 10 ppm or less.

5. The method for producing an organic electroluminescent device according to claim 3 or 4, wherein the layer is produced by a wet method using a solution with a water content of 20 ppm or less and an oxygen concentration of 10 ppm or less.
